# EUROPEAN PATENT SPECIFICATION

(11) **EP 1 100 630 B1**
(45) Date of publication and mention of the grant of the patent: **18.02.2004**
(21) Application number: 99918658.8
(22) Date of filing: 16.04.1999
(51) Int. Cl.: B08B 3/08, B08B 3/02, B08B 3/04, H01L 21/00

(54) **PROCESS AND APPARATUS FOR TREATING A WORKPIECE SUCH AS A SEMICONDUCTOR WAFER**
VERFAHREN UND GERÄT ZUR BEHANDLUNG EINES WERKSTÜCKES, WIE EIN HALBLEITERWAFER
PROCEDE ET DISPOSITIF POUR LE TRAITEMENT D'UNE PIECE A USINER TELLE QU'UNE PLAQUETTE POUR SEMI-CONDUCTEURS

(30) Priority: 16.04.1998 US 61318; 03.09.1998 US 99067 P; 19.03.1999 US 125309 P
(43) Date of publication of application: 23.05.2001
(73) Proprietor: SEMITOOL, INC., Kalispell, Montana 59901 (US)
(72) Inventor: BERGMAN, Eric, J., Kalispell, MT 59901 (US); MIGNON, P., Hess, Portland, OR 97202 (US)
(74) Representative: Viering, Jentschura & Partner
(86) International application number: PCT/US1999/008516
(87) International publication number: WO 1999/052654

(56) References cited:
- EP-A- 0 344 764
- EP-A- 0 548 596
- EP-A- 0 587 889
- US-A- 5 055 138
- US-A- 5 120 370
- US-A- 5 415 191
- US-A- 5 503 708
- US-A- 5 647 386
- US-A- 5 858 107
- US-A- 5 896 875
- PATENT ABSTRACTS OF JAPAN vol. 017, no. 125 (E-1332), 16 March 1993 (1993-03-16) & JP 04 302145 A (HITACHI LTD), 26 October 1992 (1992-10-26)

## Description

### TECHNICAL FIELD OF THE INVENTION

The present invention relates to a method of processing a workpiece in a chamber using ozone gas and a liquid applied onto the workpiece to remove material from a surface of the workpiece.

The invention further relates to an apparatus according to the pre-characterising part of claim 16.

### BACKGROUND OF THE INVENTION

From the prior art EP 0 548 592 A2 a method for cleaning semiconductor wafers and a device for processing a workpiece in a chamber is known, the method comprising the features according to the precharacterizing part of independent claim 1, and the device comprising the features according to the precharacterizing part of independent claim 16. The cleaning of semiconductor wafers is often a critical step in the fabrication processes used to manufacture integrated circuits or the like. The geometries dealt with are often on the order of fractions of a micron, while the film thicknesses may be on the order of 20 Angstroms. This renders the devices highly susceptible to performance degradation due to organic, particulates or metallic/ionic contamination. Even silicon dioxide, which is used in the fabrication structure, can be considered a contaminant if the quality or thickness of the oxide does not meet design parameters.

EP 548 596 describes a method and apparatus for treating substrates rotated within a treating chamber. Ozone gas is fed into the chamber through a feed nozzle. Ultra pure water is supplied onto the substrates through water nozzles, while the substrates are rotating. A thin film of ultra pure water is formed on the substrates. Organic materials and deposits are removed via the ozone.

US Patent No. 5,503,708 describes a method and apparatus for removing an organic film, such as photoresist. Steam and ozone are introduced into the chamber. The wafer is heated to provide an ashing process.

EP 04302145 describes a cleaning method where a wafer is rotated within a chamber. Ozone and water are heated within a vessel. Steam created in the vessel is provided into the process chamber and sprayed onto the wafer, to accelerate the organic matter removal rate.

Although wafer cleaning has a long history, the era of "modern" cleaning techniques is generally considered to have begun in the early 1970s when RCA developed a cleaning sequence to address the various types of contamination. Although others developed the same or similar processes in the same time frame, the general cleaning sequence in its final form is basically the same.

The first step of the RCA cleaning sequence involves removal of organic contamination using sulfuric acid and hydrogen peroxide mixtures. Ratios are typically in the range of 2:1 to 20: 1, with temperatures in the range of 90 - 140 degrees Celsius. This mixture is commonly called "piranha." A recent enhancement to the removal of organic contamination replaces the hydrogen peroxide with ozone that is bubbled or injected into the sulfuric acid line.

The second step of the process involves removal of oxide films with water and HF (49%) in ratios of 200:1 to 10:1, usually at ambient temperatures. This processing typically leaves regions of the wafer in a hydrophobic condition.

The next step of the process involves the removal of particles and the re-oxidation of hydrophobic silicon surfaces using a mixture of water, hydrogen peroxide, and ammonium hydroxide, usually at a temperature of about 60 - 70 degrees Celsius. Historically, ratios of these components have been in the order of 5:1:1. In recent years, that ratio has more commonly become 5:1:0.25, or even more dilute. This mixture is commonly called "SC1" (standard clean 1) or RCA1 Altematively,it is also known as HUANG1. Although this portion of the process does an outstanding job of removing particles by simultaneously growing and etching away a silicon dioxide film on the surface of a bare silicon wafer (in conjunction with creating a zeta potential which favors particle removal), it has the drawback of causing metals, such as iron and aluminum, in solution to deposit on the silicon surface.

In the last portion of the process, metals are removed with a mixture of water, hydrogen peroxide, and hydrochloric acid. The removal is usually accomplished at around 60 -70 degrees Celsius. Historically, ratios have been on the order of 5:1:1, but recent developments have shown that more dilute chemistries are also effective, including dilute mixtures of water and HCI. This mixture is commonly referred to as "SC2" (standard clean 2), RCA2, or HUANG2.

The foregoing steps are often run in sequence, constituting what is called a "pre-diffusion clean." Such a pre-diffusion clean insures that wafers are in a highly clean state prior to thermal operations which might incorporate impurities into the device layer or cause them to diffuse in such a manner as to render the device useless. Although this four-step cleaning process is considered to be the standard cleaning process in the semiconductor industry, there are many variations of the process that use the same sub-components. For example, the piranha solution may be dropped from the process, resulting in a processing sequence of: HF ->SC1 ->SC2. In recent years, thin oxides have been cause for concern in device performance, so "hydrochloric acid last" chemistries have been developed. In such instances, one or more of the above-noted cleaning steps are employed with the final clean including hydrochloric acid in order to remove the silicon backside from the wafer surface.

The manner in which a specific chemistry is applied to the wafers can be as important as the actual chemistry employed. For example, HF immersion processes on bare silicon wafers can be configured to be particle neutral. HF spraying on bare silicon wafers typically shows particle additions of a few hundred or more for particles at 0.2 microns nominal diameter.

Although the four-chemistry clean process described above has been effective for a number of years, it nevertheless has certain deficiencies. Such deficiencies include the high cost of chemicals, the lengthy process time required to get wafers through the various cleaning steps, high consumption of water due to the need for extensive rinsing between chemical steps, and high disposal costs. The result has been an effort to devise alternative cleaning processes that yield results as good as or better than the existing four-chemistry clean process, but which are more economically attractive.

Various chemical processes have been developed in an attempt to replace the existing four-chemistry cleaning process. However, such cleaning processes have failed to fully address all of the major cleaning concerns of the semiconductor processing industry. More particularly, they have failed to fully address the problem of minimizing contamination from one or more of the following contaminants: organics, particles, metals/ions, and silicon dioxide.

### BRIEF SUMMARY OF THE INVENTION

The problem is solved by a method with the features of claim 1, by a method with the features of claim 22 and by an apparatus with the features of claim 16.

Particular embodiments of the invention are the subject of the respective dependent claims.

A novel chemistry and application technique used in a chemical process sequence to address the contamination concerns of the microelectronic fabrication industry is set forth. These concerns are namely: minimizing contamination for organics, particles, metal/ions, and silicon dioxide. Generally stated, cleaning of workpieces, such as semiconductor wafers, is accomplished by delivery of a chemical stream to the workpiece surface. Ozone is delivered either into the liquid process stream or into the process environment. The chemical stream, which may be in the form of a liquid or vapor, is applied to the wafer in a system which enables control of the boundary layer which forms on the workpiece surface. The chemical stream may include components such as ammonium hydroxide for simultaneous particle and organic removal, another chemical to raise the pH of the solution, or other chemical additives designed to accomplish one or more specific cleaning tasks. The particular application technique is configured to develop and control a boundary layer of the liquid on the wafer surface.

In accordance with one embodiment of the process, the wafers that are to be cleaned are placed in a standard Teflon wafer cassette, or in a process chamber utilizing a "carrierless" rotor design. The latter design is common in wet processing tools, such as Spray Acid Tools and Spray Solvent Tools, available from Semitool, Inc., of Kalispell, Montana.

The cassette or wafers are placed in an enclosed environment, such as a processing chamber found in one of the foregoing tools available from Semitool, Inc.. During processing, the wafers and/or cassette are rotated in the chamber.

A processing solution is sprayed from a temperature controlled, recirculating chemical tank onto the wafer surface. This heats the surfaces of the wafers as well as the environment. If the spray is shut off, a thin liquid film remains on the wafer surfaces. However, it will generally be the case that the liquid spray is continued for the duration of the chemical process step. In the case where the wafer surface is hydrophobic, a surfactant may be added to the liquid chemical to create a thin film of liquid on the surfaces. The boundary layer of the processing solution at the wafer surface is controlled through the use of the rotation rate, the flow rate of the processing solution, and/or the injection technique (nozzle design) used to deliver the liquid (or steam) stream to the surfaces of the wafers.

Ozone is concurrently injected into the enclosed chamber during the liquid spray, either through the same manifold as the liquid delivery or through a separate manifold. Ozone injection may continue after the spray has shut off. If the wafer surfaces begin to dry (as in the case of a non-continuous spray), a brief spray is activated to replenish the liquid. This insures that the exposed wafer surfaces remain wetted at all times and that the elevated temperature at the wafer surfaces is also maintained. Generally, a continuous spray is preferred.

While ozone has a limited solubility in the hot liquid solution, it is still able to diffuse through the solution and react with the surface of the wafer (whether it is silicon, photoresist, etc.) at the liquid/solid interface. Thus diffusion, rather than dissolution, is the primary mechanism used to deliver ozone to the surfaces of the wafers. It is believed that water may help to hydrolyze carbon-carbon bonds or accelerate the oxidation of silicon surfaces by hydrolyzing silicon-hydrogen or silicon-hydroxyl bonds. The elevated temperature promotes the reaction kinetics and the high concentration of ozone in the gas phase promotes diffusion of the ozone through the liquid film even though the increased temperature of the liquid film does not result in a solution having a high concentration of ozone dissolved in it.

The flow of ozone can be delivered to the process chamber through a vapor generator or the like. Such a generator is filled with water, which is temperature controlled. Thus the ozone gas stream is enriched with water vapor which maintains the boundary layer on each wafer surface at a minimal thickness so that the layer does not inhibit diffusion. At the same time, such delivery assists in preventing the wafers from drying completely during the process

In a normal spray processing operations, wafer rotational speeds are in the range of 10 -100 rpm. Such low speeds tend to allow a thick boundary layer of liquid to build up on the surfaces of the wafers to create a diffusion barrier, which, in turn, inhibits the reaction rate. It has been found, however, that a continuous spray of liquid, such as the de-ionized water that is heated to maintain the surface temperature of the wafers, combined with high rotational speeds (> 300 rpm), generates a very thin boundary layer that minimizes the diffusion layer thickness thereby leading to an enhanced stripping rate. It has also been found that increases in the rotational rate of the wafers during processing results in a corresponding increase in the strip rate. For example, an increase in the rotational rate from 300 to 800 rpm results in the strip rate increasing by a factor of 2 or more. A further increase to 1500 rpm has been seen to result in another two-fold increase. Rotation rates of up to 3000 rpm are anticipated.

To further enhance the disclosed process, the temperature of the liquid supply (water supply) is heated to generate a supply of saturated steam under pressure to the process chamber. Under such circumstances, it is possible to achieve wafer surface temperatures in excess of 100 degrees Celsius, thereby further accelerating the reaction kinetics. A steam generator may be used to pressurize the process chamber to achieve the desired temperatures. For example, saturated steam at 126 degrees Celsius may be used with a corresponding increase in the pressure of the process chamber to 35 psia. The increased pressure within the processing chamber also provides for use of higher ozone concentrations, thereby generating a higher diffusion gradient across the boundary layer at the surface of each wafer. Still further, the use of steam also allows for the use of lower rotation rates to achieve the requisite thin boundary layers at the surfaces of the wafers. The oxidation rate of the ozone may also be enhanced by irradiating the surfaces of the wafers with ultra-violet light.

The present inventors have also found that it is now possible to remove particles, metals, and organics in a concurrent manner in a single processing step. Further, it is now possible to regenerate a fresh, clean, controlled chemical oxide film in that same step. To this end, certain additives may be provided in the processing liquid to specifically target certain contaminants and/or to enhance the effectiveness of the overall process. For example, ammonium hydroxide may be added to the processing liquid (e.g., deionized water) to reduce particle counts on the workpieces. In such a process, the ozone prevents pitting of the silicon surface by the ammonium hydroxide.

Other additives that enhance the cleaning capability of the overall process include HF and HCl. Such additives have the following benefits/effects: 1) removal of organic contaminants; 2) removal of oxide and regeneration of a controlled chemical oxide; 3) removal of particles; 4) removal of metals.

After one or more of the foregoing cleaning process steps has been completed, the wafers are prepared for subsequent cleaning steps. To this end, the wafers are subject to a rinsing with deionized water or a suitable aqueous solution. At this time, the ozone within the processing chamber may also be purged with, for example, a nitrogen flush.

In instances in which an additive that enhances the metal removal capabilities of the solution is not used, it may be desirable to execute a further processing step for metal removal. In one or more such cleaning steps, metal and/or silicon dioxide may be removed from the surfaces of the wafers by applying a temperature controlled mixture containing hydrofluoric acid and/or hydrochloric acid, chloroacetic acid, or other halogenated chemistry. Ozone may or may not be introduced into the liquid stream or the process environment during this step.

After one or more of the foregoing steps have been completed, including any intermediate cleaning steps, the wafers are subject to a final rinsing in deionized water or an aqueous solution. After the rinse, the wafers are dried in a manner that may include the use of heated nitrogen, another inert gas flow, or organic vapors. Additionally, the wafers may be rotated during the drying process.

The disclosed process is applicable to a number of situations that require cleaning or selective removal of contaminants from the surface of a workpiece. For example, one or more of the disclosed process steps may be used to remove photoresist from the surface of a semiconductor wafer. Still further, it is now possible to concurrently remove a layer of photoresist and a corresponding layer of an anti-reflective coating (ARC) in a single processing step using a single processing solution. More particularly, the present inventor has found that an aqueous solution having a high pH, such as a solution of ammonium hydroxide and/or tetra-methyl ammonium hydroxide and deionized water, may be used to form a controlled boundary layer that cooperate with ozone to remove both the photoresist and the anti-reflective coating.From the foregoing description, there are several novel aspects to the disclosed process. They include:
1) The use of a temperature controlled liquid chemical source delivered to the wafer surface to stabilize the temperature of the wafer and, depending on the liquid utilized, provide a supply of water to support hydrolysis of the carbon-carbon bonds of contaminants at the surface of each wafer.
2) The control of the thickness of the boundary layer of liquid present on the wafer surface so that it is not of sufficient thickness to significantly inhibit the diffusion of ozone to the wafer surface. As such, the ozone is allowed to diffuse through the controlled boundary layer, where it can oxidize silicon, organics, or metals at the surface, or otherwise support any desired reaction. The boundary layer may be controlled through the control of wafer rotation rate, vapor delivery, controlled liquid spray, the use of steam, the use of surfactants or a combination of more than one of these techniques.
3) The process takes place in an enclosed processing chamber, which may or may not be used to produce a pressurized processing environment.

### BRIEF DESCRIPTION OF THE SEVERAL VIEWS OF THE DRAWINGS

Fig. 1 is a schematic block diagram of one embodiment of an apparatus for treating a semiconductor workpiece in which ozone is injected into a line containing a pressurized treatment liquid.
Fig. 2 is a schematic block diagram of one embodiment of an apparatus for treating a semiconductor workpiece in which the semiconductor workpiece is indirectly heated by heating a treatment liquid that is sprayed on the surface of the workpiece.
Fig. 3 is a flow diagram illustrating one embodiment of a process flow for treating a semiconductor workpiece with a treatment fluid and ozone.
Fig. 4 is a schematic block diagram of an alternative embodiment of the system set forth in Fig. 2 wherein the ozone and treatment fluid are provided to the semiconductor workpiece along different flow paths.
Fig. 5 is a schematic block diagram of an embodiment of an apparatus for treating a semiconductor workpiece in which pressurized steam and ozone are provided in a pressurized chamber containing a semiconductor workpiece.
Fig. 6 is a schematic block diagram of an embodiment of an apparatus for treating a semiconductor workpiece in which an ultra-violet lamp is used to enhance the kinetic reactions at the surface of the workpiece.
Fig. 7 is a schematic block diagram of an embodiment of an apparatus for treating a semiconductor workpiece in which liquid gas contactors are used to enhance the kinetic reactions at the surface of the workpiece.

### DETAILED DESCRIPTION OF THE INVENTION

Apparatus for supplying a mixture of a treatment liquid and ozone for treatment of a surface of a workpiece, such as a semiconductor workpiece, to execute the foregoing processes are set forth below. The preferred embodiment of the apparatus comprises a liquid supply line that is used to provide fluid communication between a reservoir containing the treatment liquid and a treatment chamber housing the semiconductor workpiece. A heater is disposed to heat the workpiece, either directly or indirectly. Preferably, the workpiece is heated by heating the treatment liquid that is supplied to the workpiece. One or more nozzles accept the treatment liquid from the liquid supply line and spray it onto the surface of the workpiece while an ozone generator provides ozone into an environment containing the workpiece.

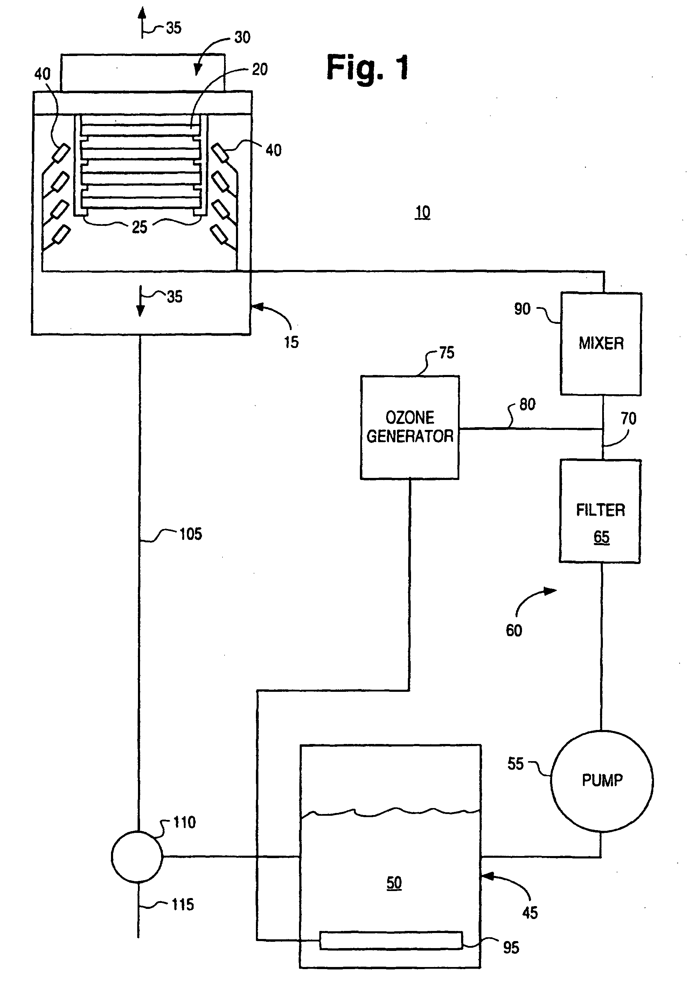

One embodiment of an apparatus suitable for providing ozone and a treatment liquid for treatment of a semiconductor workpiece in accordance with the four or processes is illustrated in Fig. 1. The treatment system, shown generally at 10, includes a treatment chamber 15 that contains one or more workpieces 20, such as semiconductor wafer workpieces. Although the illustrated system is directed to a batch workpiece apparatus, it will be recognized that the system is readily adaptable for use in single workpiece processing as well.

The semiconductor workpieces 20 are supported within the chamber 15 by one or more supports 25 extending from, for example, a rotor assembly 30. Rotor assembly 30 seals with the housing of the treatment chamber 15 to form a sealed, closed processing environment. Further, rotor assembly 30 is provided so that the semiconductor workpieces 20 may be spun about axis 35 during or after treatment with the ozone and treatment liquid.

One or more nozzles 40 are disposed within the treatment chamber 15 so as to direct a spray mixture of ozone and treatment liquid onto the surfaces of the semiconductor workpieces 20 that are to be treated. In the illustrated embodiment, the nozzles 40 direct a spray of treatment fluid to the underside of the semiconductor workpieces 20. However, it will be recognized that the fluid spray may be directed alternatively, or in addition, to the upper surface of the semiconductor workpieces 20.

Treatment liquid and ozone are supplied to the nozzles 40 with the assistance of a number of system components that are uniquely arranged to provide a single fluid line comprising ozone mixed with the treating liquid. To this end, a reservoir 45 defines a chamber 50 in which the liquid that is to be mixed with the ozone is stored. The chamber 50 is in fluid communication with the input of a pump mechanism 55. The pump mechanism 55 provides the liquid under pressure along a fluid flow path, shown generally at 60, for ultimate supply to the input of the nozzles 40. The preferred treatment fluid is deionized water, but it will be recognized that other treatment fluids, such as other aqueous or non-aqueous solutions, may also be employed.

A number of components are disposed along the fluid flow path 60. First, a filter 65 is disposed along the fluid flow path 60 to filter out microscopic contaminants from the treatment fluid. The treatment fluid, still under pressure, is provided at the output of the filter 65 along fluid flow line 70. It is along fluid flow line 70 that ozone is injected. The ozone is generated by ozone generator 75 and is supplied along fluid flow line 80 under pressure to fluid flow line 70. Optionally, the treatment liquid, now injected with ozone, is supplied to the input of a mixer 90 that mixes the ozone and the treatment liquid. The mixer 90 may be static or active. From the mixer 90, the treatment liquid and ozone are provided to be input of nozzles 40 which, in turn, spray the liquid on the surface of the semiconductor workpieces 20 that are to be treated and, further, introduce the ozone into the environment of the treatment chamber 15.

To further concentrate the ozone in the treatment liquid, an output of the ozone generator 75 may be supplied to a dispersion unit 95 disposed in the liquid chamber 50 of the reservoir 45. The dispersion unit 95 provides a dispersed flow of ozone through the treatment liquid to thereby add ozone to the fluid stream prior to injection of a further amount of ozone along the fluid path 60.

In the embodiment of the system of Fig. 1, spent liquid in chamber 15 is provided along fluid line 105 to, for example, a valve mechanism 110. The valve mechanism 110 may be operated to provide the spent liquid to either a drain output 115 or back to the liquid chamber 50 of the reservoir 45. Repeated cycling of the treatment liquid through the system and back to the reservoir 45 assists in elevating the ozone concentration in the liquid through repeated ozone injection and/or ozone dispersion.

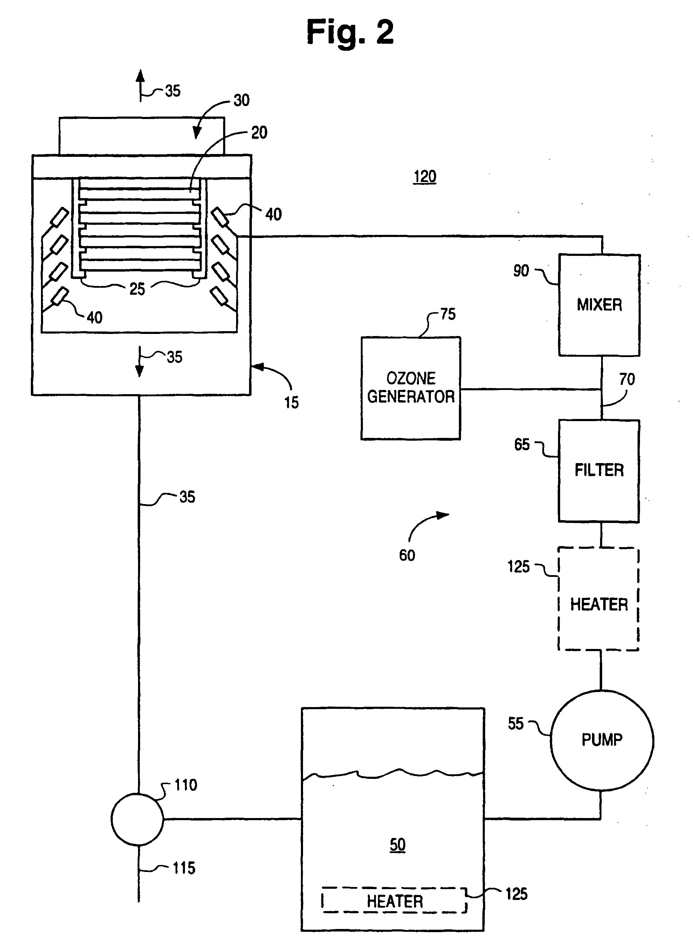

A further embodiment of a system for delivering a fluid mixture for treating the surface of a semiconductor workpiece is illustrated in Fig. 2. Although the system 120 of Fig. 2 appears to be substantially similar to the system 10 of Fig. 1, there are significant differences. The system 120 of Fig. 2 is based upon the recognition by the present inventors that the heating of the surfaces of the semiconductor workpieces 20 with a heated liquid that is supplied along with a flow of ozone that creates an ozonated atmosphere is highly effective in photoresist stripping, ash removal, and/or cleaning processes. As such, system 120 includes one or more heaters 125 that are used to heat the treatment liquid so that it is supplied to the surfaces of the semiconductor workpieces at an elevated temperature that accelerates the surface reactions. It will be recognized that it is also possible to directly heat the workpieces so as to stimulate the reactions. Such heating may take place in addition to or instead of the indirect heating of the workpieces through contact with the heated treatment liquid. For example, supports 25 may include heating elements that may be used to heat the workpieces 20. The chamber 15 may include a heater for elevating the temperature of the chamber environment and workpieces.

As noted above, the preferred treatment liquid is deionized water since it is believed to be required to initiate the cleaning/removal reactions at the workpiece surface, probably through hydrolysis of the carbon-carbon bonds of organic molecules. The present inventors, however, recognize that significant amounts of water can form a continuous film on the semiconductor workpiece surface. This film acts as a diffusion barrier to the ozone, thereby inhibiting reaction rates. Control of the boundary layer thickness, as will be explained in further detail below, is implemented by control of the rpm of the semiconductor workpiece, vapor delivery, and controlled spraying of the treatment liquid, or a combination of one or more of these techniques. By reducing the boundary layer thickness, the ozone is allowed to diffuse to the surface of the workpieces and react with the organic materials that are to be removed.

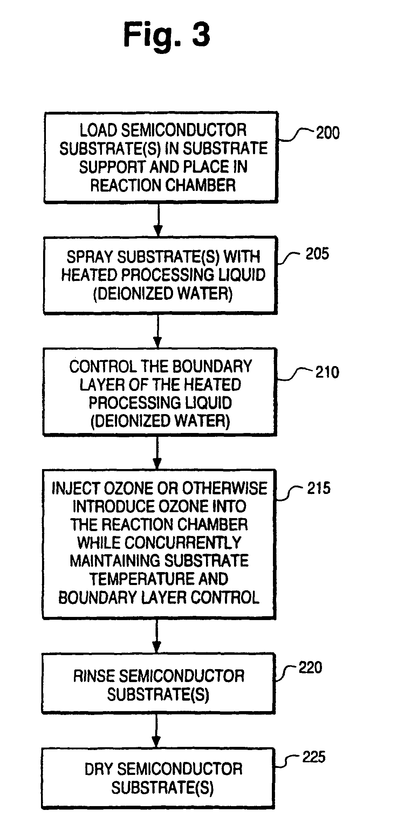

Fig. 3 illustrates one embodiment of a process that may be implemented in the system of Fig. 2 when the system 120 is used, for example, to strip photoresist from the surfaces of semiconductor workpieces. At step 200, the workpieces 20 that are to be stripped are placed in, for example, a Teflon wafer cassette. This cassette is placed in a closed environment, such as in chamber 15. Chamber 15 and its corresponding components may be constructed based on a spray solvent tool platform or spray acid tool platform such as those available from Semitool, Inc., of Kalispell, Montana. Alternatively, the semiconductor workpieces 20 may be disposed in chamber 15 in a carrierless manner, consistent with the automated processing platform design of the MAGNUM® brand semiconductor processing tool available from Semitool, Inc.

At step 205, heated deionized water is sprayed onto the surfaces of the semiconductor workpieces 20. The heated deionized water heats the surfaces of the semiconductor workpieces 20 as well as the enclosed environment of the chamber 15. When the spray is discontinued, a thin liquid film remains on the workpiece surfaces. If the surface is hydrophobic, a surfactant may be added to the deionized water to assist in creating a thin liquid boundary layer on the workpiece surfaces. In view of the teachings set forth herein, it will be recognized that a surfactant may be used in connection with hydrophilic surfaces as well. Corrossion inhibitors may also be used in conjunction with the aqueous ozone, thin boundary layer process.

The surface boundary layer of deionized water is controlled at step 210 using one or more techniques. For example, the semiconductor workpieces 20 may be rotated about axis 35 by rotor 30 to thereby generate centripetal accelerations that thin the boundary layer. The flow rate of the deionized water may also be used to control the thickness of the surface boundary layer. Lowering of the flow rate results in decreased boundary layer thickness. Still further, the manner in which the deionized water is injected into the chamber 15 may be used to control the boundary layer thickness. Nozzles 40 may be designed to provide the deionized water as micro-droplets thereby resulting in a thin boundary layer.

At step 215, ozone is injected into the fluid flow path 60 during the water spray, or otherwise provided to the internal chamber environment of chamber 15. If the apparatus of Fig. 2 is utilized, the injection of the ozone continues after the spray has shut off. If the workpiece surface begins to dry, a brief spray is preferably activated to replenish the liquid film on the workpiece surface. This ensures that the exposed workpiece surfaces remain wetted at all times and, further, ensures that the workpiece temperature is and remains elevated at the desired reaction temperature. It has been found that a continuous spray of deionized water having a flow rate that is sufficient to maintain the workpiece surfaces at an elevated temperature, and high rotational speeds (i.e., > 300 rpm, between 300 and 800 rpm, or even as high as or greater than 1500 rpm) generates a very thin boundary layer which minimizes the ozone diffusion barrier and thereby leads to an enhanced photoresist stripping rate. As such, the control of the boundary layer thickness is used to regulate the diffusion of reactive ozone to the surface of the wafer.

While ozone has a limited solubility in the heated deionized water, the ozone is able to diffuse through the water and react with photoresist at the liquid/resist interface. It is believed that the presence of the deionized water itself further assists in the reactions by hydrolyzing the carbon-carbon bonds of organic deposits, such as photoresist, on the surface of the wafer. The higher temperature promotes the reaction kinetics while the high concentration of ozone in the gas phase promotes diffusion of ozone through the boundary layer film even though the high temperature of the boundary layer film does not actually have a high concentration of dissolved ozone.

After the semiconductor workpieces 20 have been processed through the reactions of the ozone and/or liquid with the materials to the removed, the workpieces are subject to a rinse at 220 and are dried at step 225. For example, the workpieces may be sprayed with a flow of deionized water during the rinse at step 220. They may then be subject to any one or more known drying techniques thereafter at step 225.

In accordance with the foregoing process, elevated temperatures are used to accelerate the reaction rates at the wafer surface. One manner in which the surface temperature of the wafer may be maximized is to maintain a constant delivery of heated processing liquid, such as water or steam, during the process. The heated processing liquid contacts and heats the wafer during processing. However, such a constant delivery may result in significant waste of the water or other processing liquid. In order to conserve water and achieve the thinnest possible boundary layer, a " pulsed flow" of liquid or steam may be used. In instances in which such a "pulsed flow" fails to maintain the requisite elevated wafer surface temperatures, an alternative manner of maintaining the wafer surface temperature may be needed. One such alternative is the use of a "hot wall" reactor that maintains the wafer surface and processing environment temperatures at the desired level. To this end, the process chamber may be heated by, for example, one or more embedded heated recirculating coils, a heating blanket, irradiation from a thermal source (e.g., and infrared lamp), etc.

In laboratory experiments, a 150 mm silicon wafer coated with 1 micron of photoresist was stripped in accordance with the teachings of the foregoing process. The processing chamber was pre-heated by spraying deionized water that was heated to 95 degrees Celsius into the processing chamber for 10 minutes. During the cleaning process, a pulsed flow of deionized water heated to 95 degrees Celsius was used. The pulsed flow included an "on time" of approximately five seconds followed by an "off time" of 10 seconds. The wafer was rotated at 800 rpm and the pulsed flow of deionized water was sprayed into the processing chamber through nine nozzles at a rate of 3 liters per minute. Ozone was injected into the processing chamber through a separate manifold at a rate of 8 liters per minute at a concentration of 12 percent. The resultant strip rate was 7234 Angstroms/min.

There are many benefits resulting from the use of the semiconductor cleaning processes described above. One of the most significant benefits is that the conventional 4-chem clean process may be reduced to a two-chemical step process while retaining the ability to remove organics, remove particulates, reduce metals and remove silicon dioxide. Process times, chemical consumption, water consumption and waste generation are all also significantly reduced. A further benefit of the foregoing process is its applicability to both FEOL and BEOL wafers and strip processes. Laboratory tests indicate that there is no attack on metals such as aluminum, titanium, tungsten, etc. A known exception is copper, which forms a copper oxide in the presence of ozone. This oxide is not a "hard" and uniform passivation oxide, such as the oxide that forms on metals like aluminum. As a result, the oxide can be readily removed.

With reference again to Figure 3, it will be recognized that process steps 205 - 215 may be executed in a substantially concurrent manner. Additionally, it will be recognized that process steps 205 - 215 may be sequentially repeated using different processing liquids. In such instances, each of the processing liquids that are used may be specifically tailored to remove a respective set of contaminants. Preferably, however, it is desirable to use as few different processing liquids as possible. By reducing the number of different processing liquids utilized, the overall cleaning process is simplified and reducing the number of different processing liquids utilized minimizes chemical consumption.

The present inventors have developed a single processing liquid that may be utilized to remove organic contaminants, metals, and particles in a single cycle of process steps 205-215. The processing liquid is comprised of a solution of deionized water and one or more compounds, such as HF or HCl, so as to form an acidic processing liquid solution.

It has now been shown that the use of a hydrofluoric acid solution in the process steps set forth at 205-215 provides numerous advantages, including the following:
1. Removal of organic contaminants - The oxidation capability of the process has been demonstrated repeatedly on photoresist Strip rates often exceed 4000A/minute. Considering the fact that in cleaning applications, organic contamination is generally on the molecular level, the disclosed process has ample oxidation capacity.
2. Removal of oxide and regeneration of a controlled chemical oxide. Depending on the temperature of the solution and the concentration of HF in solution, a specific etch rate may be defined. However, the ozone will diffuse through the controlled boundary layer and regenerate the oxide to prevent the wafer from becoming hydrophobic. A 500:1 H₂0:HF mixture at 65 degrees C will etch SiO₂ at a rate of about 6A/minute. The same solution at 25 degrees C will etch SiO₂ at about 2A/minute. A typical "native" oxide is generally self limiting at a thickness of 8 - 12A, which is generally the targeted thickness for the oxide removal.
3. Removal of particles - Although the acidic solutions do not have the favorable zeta potential present in the SC1 clean noted above, particle removal in the disclosed process with an HF processing liquid has still been shown to be significant, as it uses the same removal mechanism of etching and regenerating the oxide surface.
4. Removal of metals - In laboratory experiments, wafers were intentionally contaminated with iron, nickel and copper. The disclosed process with an HF containing processing liquid showed a reduction in metals of over three orders of magnitude. As an added enhancement, HCI can be used in place of the HF to accomplish the metals removal, although this does not have the same degree of oxide and particle removal capability. The combination of HF and HCI is a further benefit, as each of these chemistries has significant metals removal capability, but the regeneration of the oxide surface in conjunction with the conversion of metals to metallic oxides and the symbiotic interaction of the two acid halides creates an exceptionally favorable environment for metal removal.
5. An oxide-free (hydrophobic) surface may be generated, if desired, by using a final HF step in an immersion cell or by use of an HF vapor step after the metals removal.

Typical chemical application times are in the range of 1:00 minute to 5:00.minutes Compared to a 4-chem clean process time of around 20:00 minutes, the disclosed process with an HF and/or HCl containing processing liquid becomes very attractive. Typical H₂0:HF:HCI concentration ratios are on the order of 500:1: 1 to 50: 1: 1, with and without HF and/or HCI. Higher concentrations are possible, but the economic benefits are diminished. It is important to note that gasseous HF or HCI could be injected into water to create the desired cleaning chemistry as well. Due to differences in processor configurations and desired cleaning requirements, definition of specific cleaning process parameters will vary based an these differences and requirements.

The process benefits include the following:
1. Reduction in the amount and types of chemicals used in the cleaning process.
2. Reduction in water consumption by the elimination of the numerous intermediate rinse steps required.
3. Reduction in process time.
4. Simplification of process hardware.

The disclosed processes are counter-intuitive. Efforts have been made for a number of years to replace hydrogen peroxide with ozone in chemistries such as SC1 and, to a lesser degree, SC2. These efforts have largely failed because they have not controlled the boundary layer and have not introduced the ozone in such a manner that diffusion through the boundary layer is the controlling mechanism instead of dissolution into the boundary layer. While the cleaning efficiency of conventional solutions is greatly enhanced by increasing temperature, it is recognized that the solubility of ozone in a given liquid solution is inversely proportional to the temperature of the solution. The solubility of ozone in water at 1 degrees Celsius is approximately 100 ppm. At 60 degrees Celsius, this solubility drops to less than 5 ppm. At elevated temperatures, the ozone concentration is thus insufficient to passivate (oxidize) a silicon wafer surface quickly enough to ensure that pitting of the silicon surface will not occur. Thus the two mechanisms are in conflict with one another when attempting to optimize process performance.

Tests have demonstrated that by applying the boundary layer control techniques explained in connection with the presently disclosed processes, it is possible to process silicon wafers using a 4:1 water:ammonium hydroxide solution at 95C and experience an increase surface roughness (RMS) of less than 2 angstroms. When this same solution is applied in an immersion system or in a conventional spray system, RMS surface roughness as measured by atomic force microscopy increases by more than 20 angstroms and the maximum surface roughness exceeds 190 angstroms. Additionally, while a conventional process will pit the surface to such a degree as to render the surface unreadable by a light-scattering particle counter, the boundary controlled technique has actually shown particle reductions of up to 50% on the wafer surface. In the case of oxidizing and removing organic contamination, conventional aqueous ozone processes show a strip rate an photoresist (a hydrocarbon film) of around 200 - 700 angstroms per minute. In the boundary layer controlled system of the disclosed processes, the rate is accelerated to 2500 to 7000 angstroms per minute in a spray controlled boundary layer, or 8000 angstroms per minute when the boundary layer is generated and controlled using steam at 100 kPa (15 psi) and 126 degrees C.

The disclosed processes are suitable for use in a wide range of microelectronic fabrication applications. One issue which is of concern in the manufacture of semiconductor devices is reflective notching. In order to expose a pattern an a semiconductor wafer, the wafer is coated with a photo-active compound called photoresist. The resistance film is exposed to a light pattern, thereby "exposing" the regions to which the light is conveyed. However, since topographic features may exist under the photoresist, it is possible for the light to pass through the photoresist and reflect off of a topographic feature. This results in resist exposure in an undesirable region. This phenomenon is known as "reflective notching." As device density increases, reflective notching becomes more of a problem.

A similar issue arises as a result of the reflectance normal to the incident angle of irradiation. Such reflectance can create distortions in the exposure beam through the phenomenon of standing wave formation, thereby resulting in pattern distortion in the photoresist.

In order to combat these phenomena, the use of anti-reflective coating layers has become common. The photoresist films are typically deposited either on top of or below an anti-reflective coating layer. Since both the photoresist layer and the anti-reflective coating layer are merely "temporary" layers used in intermediate fabrication steps, they must be removed after such intermediate fabrication steps are completed.

It has been found that the process of Figure 3 may be used with a processing liquid comprised of water and ammonium hydroxide to remove both the photoresist and the anti-reflective coating in a single processing step (e.g., the steps illustrated at 210-215). Although this has been demonstrated at concentrations between 0.02% and 0.04% ammonium hydroxide by weight in water, other concentrations are also considered to be viable.

The process for concurrently removing photoresist and the corresponding anti-reflective layer is not necessarily restricted to processing liquids that include ammonium hydroxide. Rather, the principal goal of the additive is to elevate the pH of the solution that is sprayed onto the wafer surface. Preferably, the pH should be raised so that it is beterrn about 8.5 and 11. Although bases such as sodium hydroxide and/or potassium hydroxide may be used for such removal, they are deemed to be less desirable due to concerns over mobile ion contamination. However, chemistries such as TMAH (tetra-methyl ammonium hydroxide) are suitable and do not elicit the same a mobile ion contamination concerns. Ionized water that is rich in hydroxyl radicals may also be used.

The dilute ammonium hydroxide solution may be applied in the process in any number of manners. For example, syringe pumps, or other precision chemical applicators, can be used to enable single-use of the solution stream. In such an embodiment, it becomes possible to strip the photoresist using a deionized water stream with ozone, and can conclude the strip 'with a brief period during which ammonium hydroxide is injected into the aqueous stream. This assists in minimizing chemical usage and waste generation. The application apparatus may also be capable of monitoring and controlling the pH the using the appropriate sensors and actuators, for example, by use of microprocessor control.

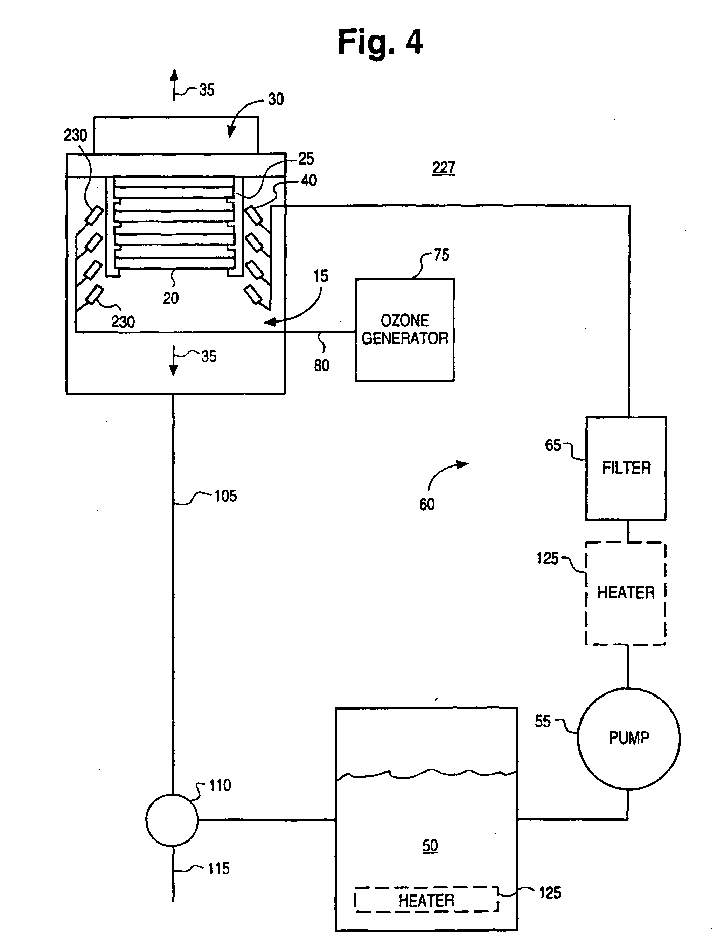

With reference to Fig. 4, there is shown yet a further embodiment of the ozone treatment system 227. In the embodiment of Fig. 4, one or more nozzles 230 are disposed within the treatment chamber 15 to conduct ozone from ozone generator 75 directly into the reaction environment. The heated treatment fluid is provided to the chamber 15 through nozzles 40 that receive the treatment fluid, such as heated deionized water, through a supply line that is separate from the ozone supply line. As such, injection of ozone in fluid path 60 is optional.

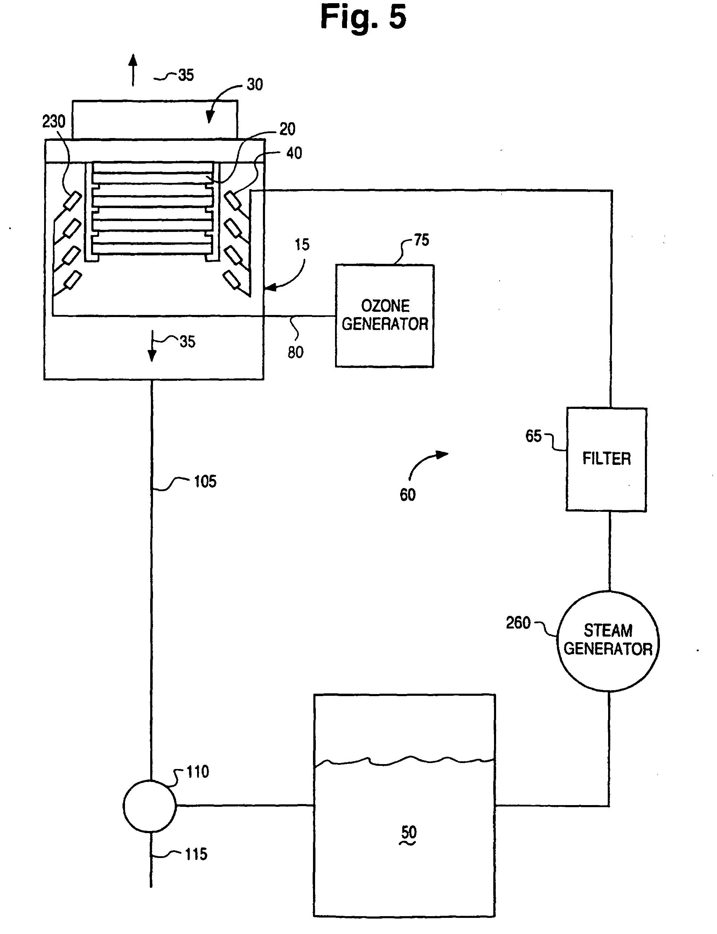

Another embodiment of an ozone treatment system is shown generally at 250 in Fig. 5. In the system 250, a steam boiler 260 that supplies saturated steam under pressure to the process chamber 15 has replaced the pump mechanism. The reaction chamber 15 is preferably sealed to thereby form a pressurized atmosphere for the reactions. For example, saturated steam at 126 degrees Celsius could be generated by steam boiler 260 and supplied to reaction chamber 15 to generate a pressure of 240 kPa (35 psia) therein during the workpiece processing. Ozone may be directly injected into the chamber 15 as shown, and/or may be injected into the path 60 for concurrent supply with the steam. Using the system architecture of this embodiment, it is thus possible to achieve semiconductor workpiece surface tempemtures in excess of 100 degrees Celsius, thereby further accelerating the reaction kinetics.

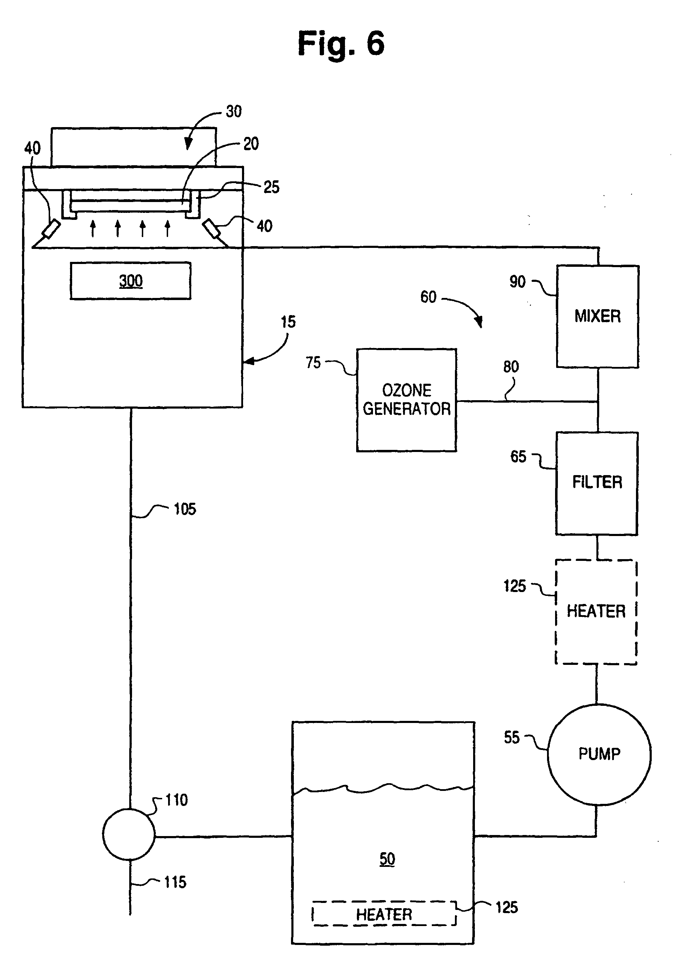

A still further enhancement that may be made to any one of the foregoing systems is illustrated in Fig. 6. In this embodiment, an ultra-violet lamp 300 is used to irradiate the surface of the semiconductor workpiece 20 during processing. Such irradiation further enhances the reaction kinetics. Although this irradiation technique is applicable to batch semiconductor workpiece processing, it is more easily and economically implemented in the illustrated single wafer processing environment where the workpiece is more easily completely exposed to the UV radiation.

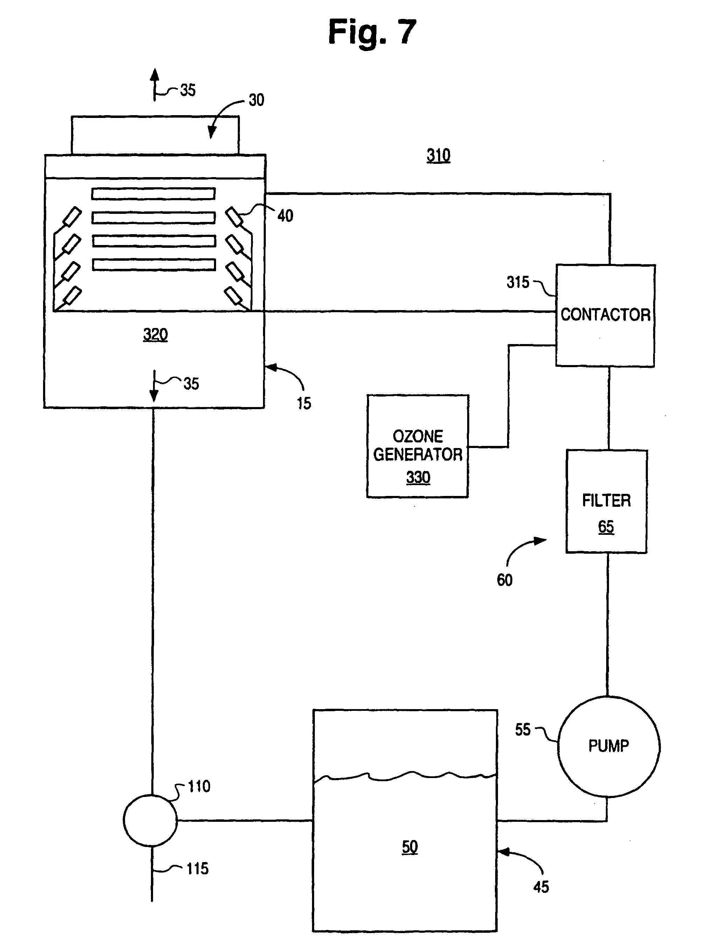

With reference to Fig. 7, a further system 310 for implementing one or more of the foregoing processes is set forth. Of particular note in system 310 is the use of one or more liquid-gas contactors 315 that are used to promote the dissolution of ozone into the aqueous stream. Such contactors are of particular benefit when the temperature of the processing liquid is, for example, at or near ambient. Such low temperatures may be required to control corrosion that may be promoted on films such as aluminum/silicon/copper.

The contactor 315 is preferably of a parallel counter-flow design in which liquid is introduced into one end and the ozone gas is introduced into the opposite end. Such contactors are manufactured and marketed by the W. L. Gore, Corp., as well as other vendors. These contactors operate under pressure, typically from about 1 to 4 atmospheres (gauge). The undissolved gas exiting the contactor 315 may be optionally directed to the process chamber 320 to minimize gas losses. However, the ozone supply 330 for the contactor 315 may or may not be the same as the supply for direct delivery to the process chamber 320.

The presently disclosed apparatus and methods may be used to treat workpieces beyond the semiconductor workpieces described above. For example, other workpieces, such as flat panel displays, hard disk media, CD glass, etc, may also be have their surfaces treated using the foregoing apparatus and methods.

Although the preferred treatment liquid for the disclosed application is deionized water, other treatment liquids may also be used. For example, acidic and basic solutions may be used, depending an the particular surface to be treated and the material that is to be removed. Treatment liquids comprising sulfuric acid, hydrochloric acid, and ammonium hydroxide may be useful in various applications.

## Claims

1. A method of processing a workpiece (20) in a chamber using ozone gas, and a liquid applied onto the workpiece, to remove material from a surface of the workpiece (20),
**characterized by**:
providing a heated liquid onto the surface of the workpiece (20) under conditions that form a liquid boundary layer that allows diffusion of ozone through the boundary layer, for reaction with the material to be removed, at a liquid-solid interface between the liquid boundary layer and the material, with the heated liquid assisting in maintaining the workpiece at an elevated temperature;
introducing gaseous ozone around the workpiece under conditions where the ozone diffuses through the boundary layer and reacts with the material,
and with the liquid heated by one or more heaters (125) before the liquid is provided onto the surface of the workpiece, or with direct heating of the workpiece itself by heating means (15, 25), or with heating by both the heater (125) and the heating means (15, 25).

2. The method of claim 1 further including the step of providing the heated liquid while concurrently rotating the workpiece to assist in forming the liquid boundary layer.

3. The method of claim 1 further including the step of providing the heated liquid onto the workpiece surface at a controlled flow rate, to assist in forming the liquid boundary layer.

4. The method of claim 1 further including the step of providing the heated liquid by spraying the heated liquid onto the workpiece surface, to form the liquid boundary layer.

5. The method of claim 1 where the heated liquid contains a surfactant, to assist in forming the liquid boundary layer.

6. The method of claim 1 where the ozone reacts with the material, and causes removal of the material at a rate of at least 2500 angstroms per minute.

7. The method of claim 1 where the heated liquid includes H2SO4, HF, HCl, or combinations of them; and/or ammonium hydroxide,; and/or de-ionized water.

8. The method of claim 3 where the liquid is heated to above boiling temperature.

9. The method of claim 3 where the workpiece is rotated at from 300-3000 rpm.

10. The method of claim 1 where the material to be removed comprises a photoresist, with the liquid includig de-ionized water and ammonium hydroxide,;
an antireflective coating, and the antireflective coating is removed concurrently with the photoresist, by reaction with the diffused ozone,; or
an existing oxide layer on the surface and, with the liquid including a solution of water and HF or HCI.

11. The method of claim 10 wherein the material to be removed comprises an existing oxide layer on the surface and, with the liquid including a solution of water and HF of HCI, further including the step of regenerating a controlled chemical oxide layer on the surface of the workpiece, after removing the existing oxide layer.

12. The method of claims 1 or 2 further including the step of pressurizing the heated liquid and injecting gaseous ozone into the heated pressurized liquid.

13. The method of claims 1 or 2 where gaseous ozone is provided at at a flow rate of at least 8 1pm at a concentration of at least 12%, or at least at a flow rate and concentration providing an equivalent amount of ozone.

14. The method of claims 1 or 2 where the gaseous ozone introduced into the environment around the workpiece comes from gaseous ozone bubbles in the heated liquid, or from dissolved ozone coming out of solution.

15. The method of claims 1 or 2 further including the step of exposing the workpiece surface to UV light, or the step of treating the workpiece in a closed chamber and pressurizing the chamber.

16. An apparatus for processing a workpiece (20) in a chamber (15) using ozone gas and a liquid applied onto the workpiece (20), comprising:
a liquid reservoir (95) for holding a process liquid (50); one or more liquid supply openings (40) positioned for applying liquid onto the workpiece (20);
a liquid path (70) extending between the liquid reservoir and the one or more liquid supply openings for carrying the liquid to the openings (40);
and
a gaseous ozone supply system (15) for providing gaseous ozone around the workpiece,
**characterized by**
a heater (25, 95, 125) for heating the liquid or the workpiece (20).

17. The apparatus of claim 16 further including a mixer (90) in the liquid path and with the ozone supply system also connected to the mixer.

18. The apparatus of claim 16 where the ozone supply system includes a contactor (315).

19. The apparatus of claim 16 with a chamber (15) around the workpiece, containing the gaseaous ozone.

20. The apparatus of claim 19 further including a recirculation liquid path (35) extending between the chamber and the liquid reservoir; a rotor assembly (30) in the chamber for holding and rotating the workpiece; gas nozzles (230) in the chamber, connected to the ozone supply system, for introducing gaseous ozone into the chamber; or chamber heaters (25) on or in the chamber, for heating the chamber directly, and for indirectly heating the workpiece.

21. The apparatus of claim 16 where the liquid supply openings are nozzles (40) for spraying out the heated liquid.

22. A method for processing a workpiece in a chamber using ozone and a liquid applied to the workpiece comprising the steps of:
loading the workpiece into a chamber;
supplying steam into the chamber;
heating the workpiece, at least in part, with the steam;
allowing at least some steam to condense as a liquid on the workpiece, to form a layer of heated liquid on the workpiece;
introducing ozone gas into the chamber;
diffusing the ozone gas through the layer of heated liquid.

23. The method of claim 22 further including the step of pressurizing the chamber.

## Patentansprüche

1. Verfahren zum Bearbeiten eines Werkstücks (20) in einer Kammer unter Verwenden von Ozon-Gas und einer auf das Werkstück aufgebrachten Flüssigkeit zum Entfernen von Material von einer Oberfläche des Werkstücks (20), das die Schritte aufweist:
Zuführen einer erhitzten Flüssigkeit auf die Oberfläche des Werkstücks (20) unter Bedingungen, die eine Flüssigkeitsgrenzschicht bilden, die eine Diffusion von Ozon zum Reagieren mit dem zu entfernenden Material an einer Flüssigkeits-Festkörper-Grenzfläche zwischen der Flüssigkeitsgrenzschicht und dem Material durch die Grenzschicht hindurch erlaubt, wobei die erhitzte Flüssigkeit dazu beträgt, das Werkstück auf einer erhöhten Temperatur zu halten;
Einbringen gasförmigen Ozons um das Werkstück herum unter Bedingungen, bei denen das Ozon durch die Grenzschicht diffundiert und mit dem Material reagiert,
und mit Erhitzen der Flüssigkeit mittels einer oder mehrerer Heizungen (125), bevor die Flüssigkeit auf die Oberfläche des Werkstücks zugeführt wird, oder mit direktem Erhitzen des Werkstücks selbst mittels Heizmitteln (15, 25), oder mit Erhitzen mittels sowohl der Heizung (125) als auch den Heizmitteln (15, 25).

2. Verfahren gemäß Anspruch 1, ferner aufweisend den Schritt des Zuführens der erhitzten Flüssigkeit während gleichzeitigem Rotieren des Werkstücks, um das Bilden der Flüssigkeitsgrenzschicht zu unterstützen.

3. Verfahren gemäß Anspruch 1, ferner aufweisend den Schritt des Zuführens der erhitzten Flüssigkeit auf die Werkstück-Oberfläche bei einer kontrollierten Flussrate, um das Bilden der Flüssigkeitsgrenzschicht zu unterstützen.

4. Verfahren gemäß Anspruch 1, ferner aufweisend den Schritt des Zuführens der erhitzten Flüssigkeit mittels Sprühens der erhitzten Flüssigkeit auf die Werkstück-Oberfläche, um die Flüssigkeitsgrenzschicht zu bilden.

5. Verfahren gemäß Anspruch 1, bei dem die erhitzte Flüssigkeit ein Tensid enthält, um das Bilden der Flüssigkeitsgrenzschicht zu unterstützen.

6. Verfahren gemäß Anspruch 1, bei dem das Ozon mit dem Material reagiert und Materialentfernung bei einer Rate von mindestens 2500 Ångström pro Minute verursacht.

7. Verfahren gemäß Anspruch 1, bei dem die erhitzte Flüssigkeit H₂SO₄, HF, HCl oder Kombinationen davon und/oder Ammoniumhydroxid und/oder entionisiertes Wasser enthält.

8. Verfahren gemäß Anspruch 3, bei dem die Flüssigkeit über die Siedetemperatur erhitzt wird.

9. Verfahren gemäß Anspruch 3, bei dem das Werkstück mit zwischen 300 und 3000 Umdrehungen pro Minute rotiert wird.

10. Verfahren gemäß Anspruch 1, bei dem das zu entfernende Material aufweist: einen Photolack, wobei die Flüssigkeit entionisiertes Wasser und Ammoniumhydroxid enthält, eine antireflektierende Beschichtung, und die antireflektierende Beschichtung wird gleichzeitig mit dem Photolack mittels Reaktion mit dem diffundierten Ozon entfernt, oder eine existierende Oxidschicht auf der Oberfläche, wobei die Flüssigkeit eine Lösung aus Wasser und HF oder HCl enthält.

11. Verfahren gemäß Anspruch 10, wobei das zu entfernende Material eine existierende Oxidschicht auf der Oberfläche aufweist, wobei die Flüssigkeit eine Lösung aus Wasser und HF oder HCl enthält, und welches ferner den Schritt des Regenerierens einer gesteuerten chemischen Oxidschicht auf der Oberfläche des Werkstücks nach dem Entfernen der existierenden Oxidschicht aufweist.

12. Verfahren gemäß Anspruch 1 oder 2, ferner aufweisend den Schritt des unter Druck Setzens der erhitzten Flüssigkeit und des Injizierens von gasförmigen Ozon in die erhitzte unter Druck stehende Flüssigkeit.

13. Verfahren gemäß Anspruch 1 oder 2, bei dem gasförmiges Ozon zugeführt wird bei einer Flussrate von mindestens 8 Liter pro Minute bei einer Konzentration von mindestens 12% oder mindestens bei einer Flussrate und einer Konzentration, welche eine äquivalente Menge an Ozon zuführen.

14. Verfahren gemäß Anspruch 1 oder 2, bei dem das in die Umgebung um das Werkstück herum eingeführte gasförmige Ozon aus gasförmigen Ozonblasen in der erhitzten Flüssigkeit oder aus gelöstem Ozon stammend aus der Lösung stammt.

15. Verfahren gemäß Anspruch 1 oder 2, ferner aufweisend den Schritt des Belichtens der Werkstück-Oberfläche mit UV-Licht oder den Schritt des Behandelns des Werkstücks in einer geschlossenen Kammer und des unter Druck Setzens der Kammer.

16. Vorrichtung zum Bearbeiten eines Werkstücks (20) in einer Kammer (15) unter Verwendung von Ozon-Gas und einer auf das Werkstück (20) aufgebrachten Flüssigkeit, aufweisend:
ein Flüssigkeits-Reservoir (95) zum Halten einer Bearbeitungsflüssigkeit (50);
eine oder mehrere Flüssigkeits-Zuführöffnungen (40), die zum Aufbringen von Flüssigkeit auf das Werkstück (20) positioniert sind;
einen sich zwischen dem Flüssigkeits-Reservoir und der einen oder den mehreren Flüssigkeits-Zuführöffnungen erstreckenden Flüssigkeitspfad (70) zum Befördern der Flüssigkeit zu den Öffnungen (40); und
ein gasförmiges Ozon-Versorgungssystem (15) zum Zuführen von gasförmigem Ozon rund um das Werkstück,
**gekennzeichnet durch**
eine Heizung (25, 95, 125) zum Erhitzen der Flüssigkeit oder des Werkstücks (20).

17. Vorrichtung gemäß Anspruch 16, ferner aufweisend einen Mischer (90) in dem Flüssigkeitspfad und wobei das Ozon-Versorgungssystem auch an den Mischer angeschlossen ist.

18. Vorrichtung gemäß Anspruch 16, bei der das Ozon-Versorgungssystem eine Kontaktierungsvorrichtung (315) aufweist.

19. Vorrichtung gemäß Anspruch 16 mit einer Kammer (15) rund um das Werkstück herum, welche das gasförmige Ozon enthält.

20. Vorrichtung gemäß Anspruch 19, ferner aufweisend einen sich zwischen der Kammer und dem Flüssigkeits-Reservoir erstreckenden Rückführungs-Flüssigkeitspfad (35), einen Rotor-Aufbau (30) in der Kammer zum Halten und Rotieren des Werkstücks, an das Ozon-Versorgungssystem angeschlossene Gasdüsen (230) in der Kammer zum Zuführen von gasförmigem Ozon in die Kammer, oder Kammer-Heizungen (25) auf oder in der Kammer zum direkten Erhitzen der Kammer und zum indirekten Erhitzen des Werkstücks.

21. Vorrichtung gemäß Anspruch 16, bei dem die Flüssigkeits-Versorgungsöffnungen Düsen (40) zum Versprühen der erhitzten Flüssigkeit sind.

22. Verfahren zum Bearbeiten eines Werkstücks in einer Kammer unter Verwenden von Ozon und einer auf das Werkstück aufgebrachten Flüssigkeit, das die Schritte aufweist:
Laden des Werkstücks in eine Kammer;
Zuführen von Dampf in die Kammer;
Erhitzen, mindestens teilweise, des Werkstücks mit dem Dampf;
Erlauben, dass mindestens etwas von dem Dampf als eine Flüssigkeit auf dem Werkstück kondensiert, um eine Schicht aus erhitzter Flüssigkeit auf dem Werkstück zu bilden;
Zuführen von Ozon-Gas in die Kammer;
Diffundieren des Ozon-Gases durch die Schicht aus erhitzter Flüssigkeit hindurch.

23. Verfahren gemäß Anspruch 22, ferner aufweisend den Schritt des unter Druck Setzens der Kammer.

## Revendications

1. Procédé pour traiter une pièce à usiner (20) dans une chambre en utilisant de l'ozone, et un liquide appliqué sur la pièce à usiner, pour retirer de la matière d'une surface de la pièce à usiner (20), **caractérisé par** les étapes consistant à :
prévoir un liquide chauffé sur la surface de la pièce à usiner (20) dans des conditions qui forment une couche limite liquide qui permet la diffusion de l'ozone à travers la couche limite, pour la réaction avec la matière à retirer, au niveau d'une interface liquide - solide entre la couche limite liquide et la matière, dont le liquide chauffé contribue à maintenir la pièce à usiner à une température élevée ;
introduire de l'ozone gazeux autour de la pièce à usiner dans des conditions dans lesquelles l'ozone diffuse à travers la couche limite et réagit avec la matière,
et avec le liquide chauffé par un ou plusieurs dispositifs de chauffage (125) avant que le liquide soit fourni sur la surface de la pièce à usiner, ou avec le chauffage direct de la pièce à usiner elle-même par des moyens de chauffage (15, 25), ou avec le chauffage à la fois du dispositif de chauffage (125) et des moyens de chauffage (15, 25).

2. Procédé selon la revendication 1 comprenant en outre l'étape consistant à fournir le liquide chauffé tout en faisant tourner simultanément la pièce à usiner pour aider à la formation de la couche limite liquide.

3. Procédé selon la revendication 1 comprenant en outre l'étape consistant à fournir le liquide chauffé sur la surface de la pièce à usiner à un débit contrôlé, pour aider à la formation de la couche limite liquide.

4. Procédé selon la revendication 1 comprenant en outre l'étape consistant à fournir le liquide chauffé en pulvérisant le liquide chauffé sur la surface de la pièce à usiner, pour former la couche limite liquide.

5. Procédé selon la revendication 1, dans lequel le liquide chauffé contient un agent de surface, pour aider à la formation de la couche limite liquide.

6. Procédé selon la revendication 1 dans lequel l'ozone réagit avec la matière, et provoque le retrait de la matière à une vitesse d'au moins 2500 angströms par minute.

7. Procédé selon la revendication 1, dans lequel le liquide chauffé comprend du H2SO4, HF, HCl, ou leurs combinaisons ; et/ou de l'hydroxyde d'ammonium ; et/ou de l'eau déminéralisée.

8. Procédé selon la revendication 3, dans lequel le liquide est chauffé au dessus de la température d'ébullition.

9. Procédé selon la revendication 3, dans lequel la pièce à usiner est entraînée en rotation à 300 - 3000 tours/minute.

10. Procédé selon la revendication 1, dans lequel la matière à retirer comprend un photorésistant, avec le liquide comprenant de l'eau déminéralisée et de l'hydroxyde d'ammonium ;
un revêtement anti-réflecteur est retiré simultanément au photorésistant, par réaction avec l'ozone diffusé ; ou
une couche d'oxyde existante sur la surface et, avec le liquide comprenant une solution d'eau et de HF ou HCI.

11. Procédé selon la revendication 10 dans lequel la matière à retirer comprend une couche d'oxyde existante sur la surface et, avec le liquide comprenant une solution d'eau et de HF ou HCI, comprenant en outre l'étape consistant à régénérer une couche d'oxyde chimique contrôlée sur la surface de la pièce à usiner, après avoir retiré la couche d'oxyde existante.

12. Procédé selon la revendication 1 ou 2 comprenant en outre l'étape consistant à mettre sous pression le liquide chauffé et injecter de l'ozone gazeux dans le liquide chauffé sous pression.

13. Procédé selon les revendications 1 ou 2 dans lequel l'ozone gazeux est fournie à une débit d'au moins 8 lpm, à une concentration d'au moins 12%, ou au moins à un débit et une concentration proposant une quantité équivalente d'ozone.

14. Procédé selon les revendications 1 ou 2, dans lequel l'ozone gazeux introduit dans l'environnement situé autour de la pièce à usiner vient des bulles d'ozone gazeux dans le liquide chauffé, ou de l'ozone dissout provenant de la solution.

15. Procédé selon les revendications 1 ou 2 comprenant en outre l'étape consistant à exposer la surface de la pièce à usiner à la lumière UV, ou l'étape consistant à traiter la pièce à usiner dans une chambre fermée et mettre la chambre sous pression.

16. Dispositif pour traiter une pièce à usiner (20) dans une chambre (15) en utilisant de l'ozone et un liquide appliqué sur la pièce à usiner (20) comprenant :
un réservoir de liquide (95) pour maintenir un liquide de traitement (50) ;
une ou plusieurs ouvertures d'alimentation de liquide (40) positionnées pour appliquer le liquide sur la pièce à usiner (20) ;
un passage de liquide (70) s'étendant entre le réservoir de liquide et les une ou plusieurs ouvertures d'alimentation de liquide pour transporter le liquide vers les ouvertures (40) ; et
un système d'alimentation en ozone gazeux (15) pour fournir l'ozone gazeux autour de la pièce à usiner,
**caractérisé en ce qu'**il comprend :
un dispositif de chauffage (25, 95, 125) pour chauffer le liquide ou la pièce à usiner (20).

17. Dispositif selon la revendication 16 comprenant en outre un mélangeur (90) dans le passage de liquide et avec le système d'alimentation en ozone également raccordé au mélangeur.

18. Dispositif selon la revendication 16, dans lequel le système d'alimentation en ozone comprend un contacteur (315).

19. Dispositif selon la revendication 16 avec une chambre (15) située autour de la pièce à usiner, contenant l'ozone gazeux.

20. Dispositif selon la revendication 19 comprenant en outre un passage de recirculation de liquide (35) s'étendant entre la chambre et le réservoir de liquide ; un bloc de rotor (30) dans la chambre pour maintenir et entraîner la pièce à usiner en rotation ; des buses de gaz (230) dans la chambre, raccordées au système d'alimentation en ozone, pour introduire l'ozone gazeux dans la chambre ; ou des dispositifs de chauffage de chambre (25) sur ou dans la chambre, pour chauffer la chambre directement, ou pour chauffer indirectement la pièce à usiner.

21. Dispositif selon la revendication 16 dans lequel les ouvertures d'alimentation de liquide sont des buses (40) pour pulvériser le liquide chauffé.

22. Procédé pour traiter une pièce à usiner dans une chambre en utilisant de l'ozone et un liquide appliqué sur la pièce à usiner comprenant les étapes consistant à :
charger la pièce à usiner dans une chambre ;
fournir de la vapeur dans la chambre ;
chauffer la pièce à usiner, au moins en partie, avec la vapeur ;
permettre au moins à une certaine partie de vapeur de se condenser sous forme d'un liquide sur la pièce à usiner, pour former une couche de liquide chauffé sur la pièce à usiner ;
introduire l'ozone dans la chambre ;
diffuser l'ozone à travers la couche de liquide chauffé.

23. Procédé selon la revendication 22 comprenant en outre l'étape consistant à mettre la chambre sous pression.
